# FASCICULE DE BREVET EUROPEEN

(11) **EP 0 642 157 B1**
(45) Date de publication et mention de la délivrance du brevet: **03.02.1999**
(21) Numéro de dépôt: 94401965.2
(22) Date de dépôt: 05.09.1994
(51) Int. Cl.: H01L 21/60, H01L 21/58

(54) **Procédé d'assemblage de composants par collage**
Verfahren zur Anordnung von Bauelementen mittels Kleber
Method of assembly of components by bonding with glue

(30) Priorité: 06.09.1993 FR 9310558
(43) Date de publication de la demande: 08.03.1995
(73) Titulaire: COMMISSARIAT A L'ENERGIE ATOMIQUE, 75015 Paris (FR)
(72) Inventeur: Marion, François, F-38120 Saint-Egreve (FR); Boitel, Michelle, F-38600 Fontaine (FR); Truchot, Jean-Pierre, F-38100 Grenoble (FR)
(74) Mandataire: Dubois-Chabert, Guy

(56) Documents cités:
- EP-A- 0 189 791
- EP-A- 0 348 972
- EP-A- 0 449 496
- PATENT ABSTRACTS OF JAPAN vol. 015, no. 482 (E-1142) 6 Décembre 1991 & JP-A-03 209 840 (MATSUSHITA ELECTRIC IND CO LTD) 12 Septembre 1991
- PATENT ABSTRACTS OF JAPAN vol. 015, no. 135 (E-1052) 4 Avril 1991 & JP-A-03 016 148 (MATSUSHITA ELECTRIC IND CO LTD) 24 Janvier 1991
- PROCEEDINGS OF THE 43RD ELECTRONIC COMPONENTS & TECHNOLOGY CONFERENCE, 1 Juin 1993, ORLANDO, FLORIDA pages 992 - 996 'A FINE PITCH COG TECHNIQUE FOR A TFT-LCD PANEL USING AN INDIUM ALLOY'

## Description

La présente invention concerne un procédé d'assemblage de composants, ou pièces, comme par exemple des composants électroniques ou des pièces utilisées pour fabriquer des capteurs de pression.

Pour coller une pièce à une autre, il est connu de verser sur l'une de ces pièces une goutte de colle liquide au moyen d'un système à seringue qui permet de fournir une quantité extrêmement précise de colle, puis d'appliquer l'autre pièce contre celle sur laquelle se trouve la colle.

Cependant, une colle liquide, une fois déposée, flue et se répartit sans qu'il soit possible de maîtriser cette répartition.

Pour remédier à cet inconvénient, il est possible de choisir une colle de viscosité suffisamment élevée et de déposer sur la pièce des gouttes de colle qui resteront en forme une fois déposées.

Cependant, ceci nécessite d'utiliser des colles de forte viscosité et de travailler à travers des écrans de sérigraphie.

Une autre technique connue pour maîtriser la répartition de la colle consiste à réaliser des épaulements bien définis sur les surfaces à encoller afin de limiter l'étalement de la colle à une zone bien précise.

Cependant, cette autre technique connue, qui utilise des épaulements, est assez complexe.

La technique connue sous le nom de "flip-chip", qui est largement décrite dans la littérature scientifique, a conduit à rechercher des procédés d'assemblages faisant appel aux colles et non pas aux billes de soudure ("solder balls" dans les articles en langue anglaise).

On évite ainsi les montées en température de composants électroniques à assembler.

Un tel procédé faisant appel à une colle, est décrit dans le document suivant :
US-A-5 074 947 "Flip-chip technology using electrically conductive polymers and dielectrics".

Cependant, il s'agit d'un procédé complexe et coûteux, qui nécessite une colle conductrice, chargée de particules métalliques, qu'il faut répandre à travers un écran et retenir par des épaulements.

La présente invention a pour but de remédier aux inconvénients précédents en proposant un procédé d'assemblage de composants qui permette de maîtriser la répartition de la colle et ne nécessite ni colle conductrice ni épaulements sur les composants à assembler.

On connaît par Patent Abstracts of Japan, vol. 015, N°135 (E-1052) une technique de connexion selon laquelle un circuit integré muni d'électrodes en forme de boules est collé à un support d'interconnexion au moyen d'une résine. La résine est disposée dans une zone ne comprenant aucune électrode en forme de boule. On connaît aussi par EP-A-0 189 791 (INTERNATIONAL BUSINESS MACHINES CORP.) un procédé d'assemblage d'un circuit intégré et d'un substrat comprenant des boules de soudure. Après l'assemblage, une résine isolante est appliquée sur le pourtour de l'ensemble formé par le circuit intégré et le substrat qui sont reliés par les boules de soudure. On connaît en outre par Proceeding of the 43rd Electronic Components & Technology Conference un procédé d'assemblage d'un circuit intégré et d'un substrat portant des plots conducteurs. Après l'assemblage, l'ensemble obtenu est enrobé dans une résine de scellement.

De façon précise, la présente invention a pour objet un procédé d'assemblage d'un premier composant et d'un deuxième composant, conformément à la revendication 1.

De préférence, la colle est électriquement isolante, ce qui permet de choisir une colle très fluide et, par conséquent, de n'avoir à exercer qu'une faible pression (voire même aucune pression) sur l'un des composants pour l'assembler à l'autre composant.

Le diamètre des billes peut être choisi dans l'intervalle allant de 4 µm à 100 µm.

Les billes peuvent être réparties dans le tapis avec un pas supérieur au diamètre des billes et choisi dans l'intervalle allant de 10 µm à 150 µm.

De préférence, la colle est versée sur le tapis au moyen d'une microseringue qui est parfaitement adaptée à la fourniture de faibles quantités de colle.

Ledit tapis peut former une couronne, ce tapis délimitant une zone centrale dépourvue de billes, de sorte qu'après fixation des premier et deuxième composants l'un à l'autre, l'intérieur de cette couronne (c'est-à-dire l'espace délimité par celle-ci) est isolé de l'extérieur de la couronne.

Dans ce cas, on peut mettre les premier et deuxième composants au contact l'un de l'autre et faire sécher la colle à une pression déterminée, de sorte qu'après fixation des premier et deuxième composants l'un à l'autre, l'intérieur de la couronne reste à cette pression déterminée.

La présente invention sera mieux comprise à la lecture de la description d'exemples de réalisation donnés ci-après, à titre purement indicatif et nullement limitatif, en faisant référence aux dessins annexés sur lesquels :
- la figure 1 illustre schématiquement une étape d'un mode de mise en oeuvre particulier du procédé objet de l'invention, étape dans laquelle de la colle est versée sur des tapis de billes d'un composant que l'on veut assembler à un autre composant,
- la figure 2 illustre schématiquement une autre étape dans laquelle on assemble les deux composants l'un à l'autre, et
- la figure 3 est une vue en coupe schématique qui illustre un autre procédé conforme à l'invention, dans lequel on utilise un tapis de billes en forme de couronne.

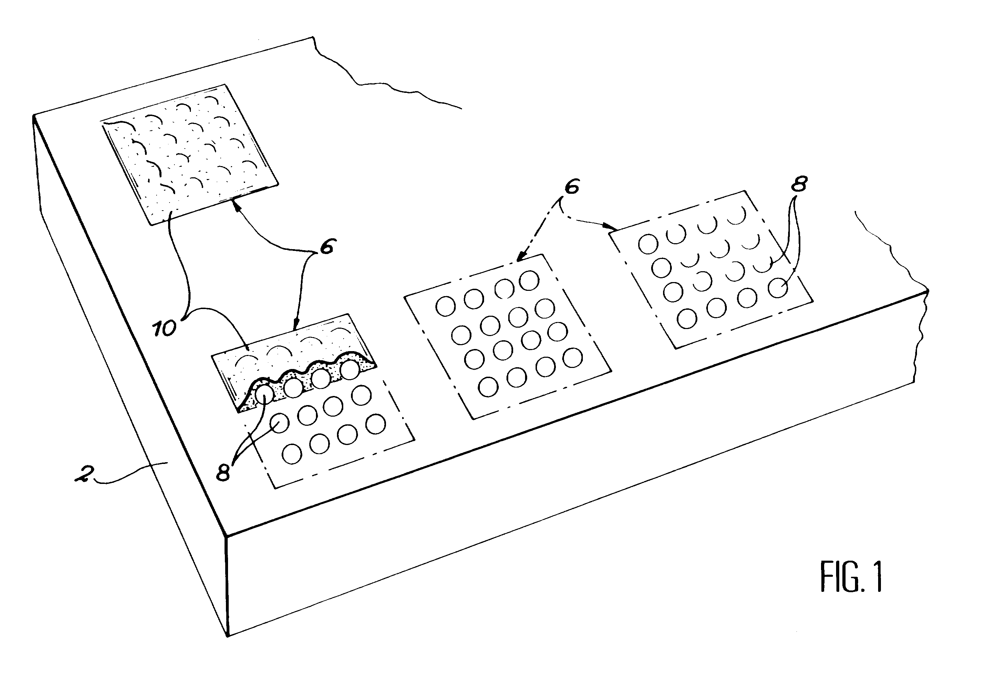

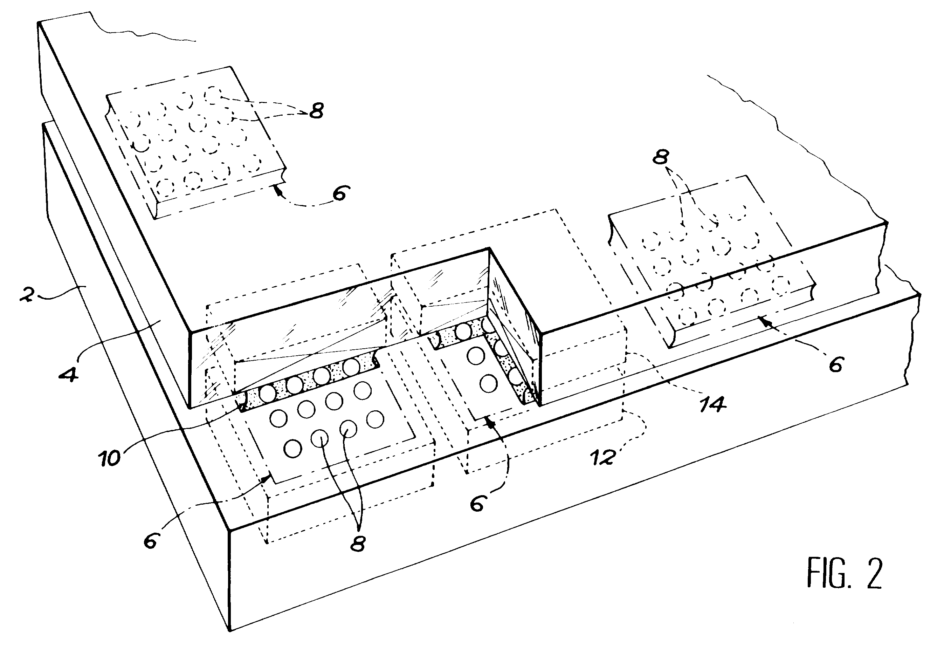

On décrit ci-après, en faisant référence aux figures 1 et 2, un procédé conforme à l'invention, permettant d'assembler un premier composant électronique 2 à un deuxième composant électronique 4.

Pour ce faire, on commence par former, sur le premier composant 2, en des zones où l'on veut réaliser la liaison entre les composants 2 et 4, des "tapis" 6 de billes 8, ces billes ayant sensiblement le même diamètre, étant espacées les unes des autres et étant fixées au premier composant 2.

L'obtention de tels tapis de billes a largement été décrite dans la littérature scientifique pour les applications de la technique connue sous le nom de "flip-chip".

On se référera par exemple au document suivant :

EP-A-0 395 488 (voir aussi US-A-5 131 584).

On sait réaliser des billes électriquement conductrices, de taille calibrée, à partir d'un matériau de soudure, comme par exemple l'indium pur ou un alliage d'étain et de plomb.

La hauteur des billes peut varier de 4 µm à 100 µm suivant l'application considérée (on peut donc parler de microbilles).

L'obtention des billes par la technique décrite dans le document cité ci-dessus nécessite que le composant 2 comporte des plots ("pads" dans les articles en langue anglaise) électriquement conducteurs (non représentés) dans chacune des zones où l'on souhaite former les billes, chaque bille de soudure étant formée sur un tel plot.

Pour réaliser l'assemblage des composants 2 et 4, on dépose, au moyen d'une microseringue, une dose précise (goutte calibrée) d'une colle liquide en un endroit quelconque de chacun des tapis de billes 8 formés, cette colle étant apte à adhérer aux composants 2 et 4.

Pour l'assemblage de composants on peut utiliser une colle de viscosité inférieure à 3000 cps.

La goutte de colle, lorsqu'elle a été déposée, migre par capillarité sur le tapis de billes correspondant et s'étend sur l'ensemble de ce tapis en se limitant à ce dernier, restant ainsi confinée sur celui-ci par capillarité.

Sur chacune des zones, les billes sont réparties avec un pas qui est déterminé en fonction de la viscosité de la colle choisie, à la température choisie pour déposer cette colle, les forces de capillarité dépendant essentiellement de ces deux paramètres que sont la viscosité et la température.

Ce pas peut aller de 10 µm à 150 µm, ce qui permet d'appliquer le procédé objet de l'invention avec une gamme étendue de viscosités.

On précise que ce pas peut être déterminé à l'aide d'essais réalisés sur des maquettes d'étalonnage.

Bien entendu, on dépose sur chacune des zones un volume suffisant de colle pour que la hauteur de la couche de colle ainsi obtenue dépasse la hauteur des billes de cette zone, enrobant ainsi le tapis de billes.

On met ensuite le composant 4 en contact avec le composant 2, les billes venant au contact du composant 4 (figure 2), la colle se répartissant par effet de capillarité entre ces deux composants, tout en restant confinée dans chacun des tapis de billes.

Ceci permet d'obtenir un collage avec une localisation précise des points de colle.

Chaque tapis de billes électriquement conductrices permet d'établir un contact électrique et thermique entre les composants.

Dans le procédé objet de l'invention, le collage peut se faire sans chauffage (collage "à froid").

Dans l'exemple donné de l'assemblage de deux composants électroniques, il sera généralement nécessaire de disposer en regard les unes des autres des zones bien précises de ces composants (et de coller ces zones l'une à l'autre), en particulier si l'on souhaite réaliser des connexions électriques entre ceux-ci.

On se reportera au document suivant :
Article de F.W. Kulesza et R.H. ESTES, publié dans Hybrid Circuit Technology, Février 1992, et intitulé "Solderless flip chip technology"
dans lequel est expliqué le mode d'alignement de tels circuits intégrés en vue d'un collage.

La figure 2 illustre un exemple dans lequel un circuit intégré 12 du composant 2 doit être électriquement connecté à un circuit intégré 14 du composant 4.

Ce contact électrique est établi par l'intermédiaire des billes ou de certaines billes, d'un tapis de telles billes qui est formé au-dessus du circuit intégré 12.

Dans ce cas, il convient que le composant 4 comporte, au-dessus du circuit intégré 14, des plots électriquement conducteurs (non représentés) en correspondance avec chacun des plots du composant 2 qui porte les billes destinées à établir la liaison électrique entre les deux circuits intégrés 12 et 14.

Il est à noter que, dans la présente invention, la colle utilisée peut être très fluide (puisque cette colle n'a pas besoin d'être électriquement conductrice et n'a donc pas besoin d'être chargée de particules métalliques).

Ainsi, la pression à exercer sur l'un des composants pour l'assembler à l'autre composant peut être très faible voire nulle (les forces de capillarité, qui s'exercent entre les deux composants du fait de la colle, ayant tendance à assembler ces composants l'un à l'autre).

De ce fait, l'établissement des contacts électriques (nécessitant que chaque bille concernée touche les deux plots corrrespondants, placés en regard l'un de l'autre) est facilité.

La conduction thermique d'un composant à l'autre est sensiblement améliorée en les points où se trouvent les billes par rapport aux points où il n'y a que de la colle (la conduction thermique des matériaux de soudure étant de l'ordre de 30 à 70 W/m.K, alors qu'elle est seulement de l'ordre de 0,1 à 2 W/m.K pour les colles traditionnelles).

A titre purement indicatif et nullement limitatif, pour connecter deux circuits intégrés, on peut réaliser, à la périphérie de l'un d'entre eux, des tapis de 4x6=24 microbilles conductrices de 10 µm de diamètre, espacées les unes des autres de 20 µm et reposant sur des plots électriquement conducteurs préalablement formés sur ce circuit intégré, des plots électriquement conducteurs, disposés de manière identique étant également prévus sur l'autre circuit intégré.

On précise que, lorsque les composants 2 et 4 sont en contact l'un avec l'autre, on fait sécher la colle.

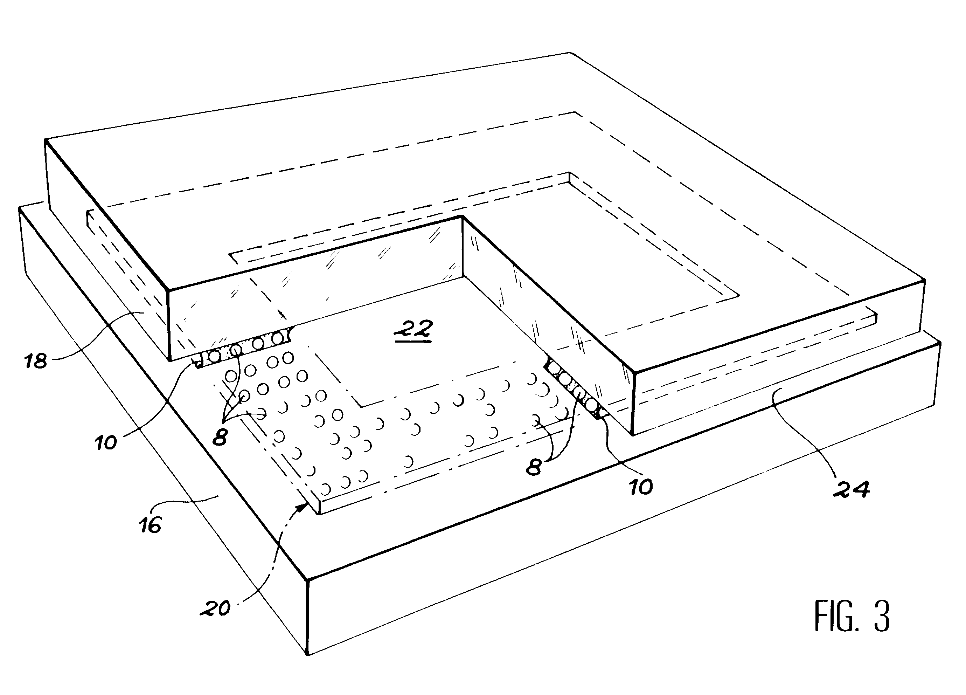

La figure 3 illustre schématiquement un autre mode de mise en oeuvre particulier du procédé objet de l'invention.

On veut assembler une pièce 16 à une pièce 18, la pièce 16 portant un tapis 20 de microbilles 10 sur une zone en forme de couronne.

On dépose une ou plusieurs gouttes de colle sur ce tapis de microbilles et cette colle va se répandre sur toute la zone par capillarité, sans occuper l'intérieur de la couronne (c'est-à-dire le domaine 22 délimité par cette couronne) ni d'ailleurs le domaine 24 extérieur à cette couronne.

On colle ensuite la pièce 18 sur la pièce 16 de façon que la couronne de microbilles soit comprise entre les deux pièces comme on le voit sur la figure 3.

Après avoir fait sécher la colle, cette dernière isole de façon étanche le domaine intérieur 22 du domaine extérieur 24.

Un tel procédé permet d'obtenir une pression déterminée dans le domaine intérieur 22 (basse pression ou pression atmosphérique ou haute pression).

Pour ce faire, les microbilles ainsi que l'encollage sont réalisés à la pression atmosphérique.

En revanche, le collage des deux pièces et le séchage (réticulation) de la colle sont réalisés à la pression souhaitée dans une enceinte à cette pression.

A la sortie de cette enceinte, le domaine intérieur 22 se trouve isolé et à la pression choisie (pression régnant dans l'enceinte).

On peut même enfermer un gaz à la pression souhaitée dans ce domaine 22 si l'enceinte contient ce gaz à cette pression.

La présente invention permet de localiser exactement la colle sur une ou des zones déterminées.

La connaissance précise du volume de colle déposée permet de maîtriser la hauteur de colle déposée.

L'invention permet également d'obtenir un contact électrique en des points déterminés de deux composants assemblés conformément à l'invention sans avoir à chauffer ceux-ci jusqu'au point de fusion du matériau constitutif des microbilles.

La présente invention trouve en particulier des applications dans le domaine de la micro-électronique.

Elle s'applique notamment à l'assemblage, par une technique "flip-chip", de composants nécessitant un assemblage à faible température, et est donc intéressante pour les assemblages du type COG ("chip on glass"), les cellules à cristaux liquides, les lasers et les circuits à jonctions Josephson.

L'invention est également utilisable pour la fabrication de dispositifs, tels que certains lasers, nécessitant un collage avec une importante conductivité thermique ainsi que pour les procédés de fabrication de dispositifs nécessitant l'obtention de domaines isolés du point de vue de la pression, comme par exemple les capteurs de pression en silicium.

## Revendications

1. Procédé d'assemblage d'un premier composant (2, 16) et d'un deuxième composant (4, 18), ce procédé comprenant les étapes suivantes :
- on forme sur le premier composant des billes (8) qui ont sensiblement la même hauteur, et sont fixées au premier composant,
- on verse sur ce dernier au moins une goutte d'une colle (10) apte à adhérer aux premier et deuxième composants,
- on met les premier et deuxième composants en contact l'un avec l'autre, de façon que la colle adhère au deuxième composant, et
- on fait sécher la colle, pour fixer l'un à l'autre les premier et deuxième composants,
caractérisé en ce que les billes forment au moins un tapis (6,20) où elles sont espacées les unes des autres avec un pas déterminé, la colle est versée sur chaque tapis, le pas avec lequel les billes sont réparties dans le tapis étant adapté à la viscosité de la colle pour permettre une rétention de cette colle dans le tapis par capillarité, cette colle se répandant ainsi sur ce tapis et y restant confinée par capillarité.

2. Procédé selon la revendication 1, caractérisé en ce que la colle (10) est électriquement isolante.

3. Procédé selon l'une quelconque des revendications 1 et 2, caractérisé en ce que la hauteur des billes (8) est choisie dans l'intervalle allant de 4 µm à 100 µm.

4. Procédé selon l'une quelconque des revendications 1 à 3, caractérisé en ce que les billes (8) sont réparties dans le tapis (6, 20) avec un pas supérieur au diamètre des billes et choisi dans l'intervalle allant de 10 µm à 150 µm.

5. Procédé selon l'une quelconque des revendications 1 à 4, caractérisé en ce que la colle (10) est versée sur le tapis (6, 20) au moyen d'une microseringue.

6. Procédé selon l'une quelconque des revendications 1 à 5, caractérisé en ce que le tapis forme une couronne (20), ce tapis délimitant une zone centrale dépourvue de billes, de sorte qu'après fixation des premier (16) et deuxième (18) composants l'un à l'autre, l'intérieur (22) de cette couronne est isolé de l'extérieur (24) de celle-ci.

7. Procédé selon la revendication 6, caractérisé en ce que les premier (16) et deuxième (18) composants sont mis au contact l'un de l'autre et l'on fait sécher la colle (10) à une pression déterminée, de sorte qu'après fixation des premier et deuxième composants l'un à l'autre, l'intérieur (22) de la couronne reste à cette pression déterminée.

## Claims

1. Method of joining together a first component (2, 16) and a second component (4, 18), this method comprising the following steps:
- balls (8) are formed on the first component, these balls having approximately the same height and being fixed to the first component,
- at least one drop of an adhesive (10) capable of adhering to the first and second components is poured onto the first component,
- the first and second components are brought into contact with each other so that the adhesive adheres to the second component, and
- the adhesive is dried in order to fix the first and second components to each other,
characterized in that the balls form at least one mat (6, 20) in which they are spaced apart with a defined spacing and the adhesive is poured onto each mat, the spacing with which the balls are distributed in the mat being tailored to the viscosity of the adhesive in order to allow this adhesive to be retained in the mat by capillary effect, this adhesive thus spreading out over this mat and remaining confined therein by capillary effect.

2. Method according to Claim 1, characterized in that the adhesive (10) is electrically insulating.

3. Method according to either of Claims 1 and 2, characterized in that the height of the balls (8) is chosen to lie within the range from 4 µm to 100 µm.

4. Method according to any one of Claims 1 to 3, characterized in that the balls (8) are distributed in the mat (6, 20) with a spacing greater than the diameter of the balls and is chosen to lie in the range from 10 µm to 150 µm.

5. Method according to any one of Claims 1 to 4, characterized in that the adhesive (10) is poured onto the mat (6, 20) by means of a microsyringe.

6. Method according to any one of Claims 1 to 5, characterized in that the mat forms a ring (20), this mat delimiting a central region devoid of balls so that, after the first component (16) and the second component (18) have been fixed to each other, the inside (22) of this ring is insulated from the outside (24) of the latter.

7. Method according to Claim 6, characterized in that the first component (16) and the second component (18) are brought into contact with each other and the adhesive (10) is dried under a defined pressure so that, after the first and second components have been fixed to each other, the inside (22) of the ring remains under this defined pressure.

## Patentansprüche

1. Verfahren zur Anordnung bzw. zum Zusammenbau eines ersten Bauelements (2, 16) und eines zweiten Bauelements (4, 18), folgende Schritte umfassend:
- man bildet auf dem ersten Bauelement Kugeln (8), die im wesentlichen dieselbe Höhe haben und am ersten Bauelement befestigt sind,
- man gießt auf dieses letztere wenigstens einen Tropfen eines Klebstoffs (10), geeignet am ersten und am zweiten Bauelement zu haften,
- man bringt das erste und das zweite Bauelement miteinander in Kontakt, so daß der Klebstoff am zweiten Bauelement haftet, und - man läßt den Klebstoff trocknen, um das erste und das zweite Bauelement aneinander zu befestigen,
**dadurch gekennzeichnet,**
daß die Kugeln wenigstens einen Teppich (6, 20) bilden, wo sie mit einer bestimmten Teilung voneinander beabstandet sind, der Klebstoff auf jeden Teppich gegossen wird, und die Teilung, mit der die Kugeln voneinander beabstandet sind, angepaßt ist an die Viskosität des Klebstoffs, um sicherzstellen, daß dieser Klebstoff durch Kapillarwirkung in dem Teppich zurückgehalten wird, wobei dieser Klebstoff sich folglich über diesem Teppich ausbreitet und dort durch Kapillarkraft zusammengehalten wird.

2. Verfahren nach Anspruch 1, dadurch gekennzeichnet, daß der Klebstoff (10) elektrisch isolierend ist.

3. Verfahren nach einem der Ansprüche 1 und 2, dadurch gekennzeichnet, daß die Höhe der Kugeln (8) in dem Bereich von 4µm bis 100µm gewählt wird.

4. Verfahren nach einem der Ansprüche 1 bis 3, dadurch gekennzeichnet, daß die Kugeln (8) in dem Teppich (6, 20) mit einer Teilung verteilt sind, die größer als der Durchmesser der Kugeln ist und in dem Bereich von 10µm bis 150µm gewählt wird.

5. Verfahren nach einem der Ansprüche 1 bis 4, dadurch gekennzeichnet, daß der Klebstoff (10) mit Hilfe einer Mikrospritze auf dem Teppich (6, 20) vergossen wird.

6. Verfahren nach einem der Ansprüche 1 bis 5, dadurch gekennzeichnet, daß der Teppich einen Kranz (20) bildet, wobei dieser Teppich eine zentrale Zone ohne Kugeln abgrenzt, so daß die Innenseite (22) dieses Kranzes von seiner Außenseite isoliert ist, nachdem man das erste (16) und das zweite (18) Bauelement aneinander befestigt hat.

7. Verfahren nach Anspruch 6, dadurch gekennzeichnet, daß das erste (16) und das zweite (18) Bauelement miteinander in Kontakt gebracht werden und man den Klebstoff (10) bei einem bestimmten Druck trocknen läßt, so daß dieser Druck auf der Innenseite (22) des Kranzes erhalten bleibt, nachdem man das erste und das zweite Bauelement aneinander befestigt hat.
